Europäisches Patentamt

European Patent Office

Office européen des brevets

(11) Veröffentlichungsnummer: **0 180 072 B1**

## EUROPÄISCHE PATENTSCHRIFT

(45) Veröffentlichungstag der Patentschrift: **11.03.92**

(51) Int. Cl.⁵: **G01R 31/28**

(21) Anmeldenummer: **85112740.7**

(22) Anmeldetag: **08.10.85**

(54) **Verfahren zur Fehleranalyse an integrierten Schaltungen.**

(30) Priorität: **12.10.84 DE 3437550**

(43) Veröffentlichungstag der Anmeldung:
**07.05.86 Patentblatt 86/19**

(45) Bekanntmachung des Hinweises auf die
Patenterteilung:
**11.03.92 Patentblatt 92/11**

(84) Benannte Vertragsstaaten:
**DE FR GB IT NL SE**

(56) Entgegenhaltungen:
**US-A- 3 942 005**

**TRANSACTIONS OF THE INSTITUTE OF ELECTRICAL AND COMM. ENGINEERS OF JA-PAN, Band E 64, Nr. 5, Mai 1981, Seiten 295-301, Tokyo, Japan; H. FUJIOKA et al.: "Function testing of bipolar and MOS LSI circuits with a combined stoboscopic SEM-microcomputer system"**

**IEEE ELECTRON DEVICES, Band ED-27, Nr. 8, August 1980, Seiten 1321-1331, New York, US; Y. TARUI: "Basic technology for VLSI (Part II)**

**PHYSIKALISCHE BLÄTTER, Band 38, Nr. 8,**

**1982, Seiten 253-258; H. REHME: "Elektronenstrahl-Messtechnik zur Prüfung integrierter Schaltungen"**

**ELEKTRONIK SONDER-PUBLIKATION CAD-CAM, Band 18, 7. September 1984, Seiten 165-169,; K. DEHRMANN: "Entwicklungstrends bei Engineering Work-stations"**

(73) Patentinhaber: **ICT Integrated Circuit Testing Gesellschaft für Halbleiterprüftechnik mbH Klausnerring 1a W-8011 Heimstetten(DE)**

(72) Erfinder: **Wolfgang, Eckhard, Dr. Winternitzstrasse 6 W-8000 München(DE)**
Erfinder: **Zibert, Klaus, Dr. Ing. Kiem-Pauli-Strasse 19 W-8150 Holzkirchen(DE)**

(74) Vertreter: **Tetzner, Volkmar, Dr.-Ing. Dr. jur. Van-Gogh-Strasse 3 W-8000 München 71(DE)**

# Beschreibung

Die Erfindung bezieht sich auf Verfahren zur Fehleranalyse an integrierten Schaltungen nach dem Oberbegriff des Patentanspruchs 1.

Arbeitsstationen (workstations) sind beispielsweise in der Sonder-Publikation CADCAM der Zeitschrift "Elektronik", Bd. 18 vom 7.9.1984 auf den Seiten 165-169 beschrieben. Hierunter sind Arbeitsplatzrechner zu verstehen, die z.B. beim Entwurf von monolithisch integrierten Schaltungen sowohl zur Erstellung und Darstellung des Stromlaufplans als auch zur logischen Simulation der Schaltung und zur Erstellung des Layouts herangezogen werden können.

Andererseits sind Elektronenstrahlmeßgeräte und Elektronenstrahlmeßverfahren zur Fehleranalyse an integrierten Schaltungen bekannt, so z.B. aus Scanning Electron Microsc. 1983 IV, Seiten 1595-1604, aus dem Tagungsband der IEEE Computer Society, Test Technology Committee, vom 16. und 17. Nov. 1983 (Curriculum for Test Technology, Minneapolis) Seiten 26-31 oder aus Phys. Bl. 38 (1982) No. 8, Seiten 253-258.

Der Erfindung liegt die Aufgabe zugrunde, ein Verfahren der eingangs angedeuteten Art unter Verwendung einer Arbeitsstation und eines Elektronenstrahlmeßgeräts anzugeben, bei dem ein möglichst einfacher Meßdatentransfer zwischen der Arbeitsstation und dem Elektronenstrahlmeßgerät erfolgt. Das wird erfindungsgemäß durch eine Ausgestaltung des Verfahrens nach dem kennzeichnenden Teil des Patentanspruchs 1 erreicht.

Der mit der Erfindung erzielbare Vorteil besteht insbesondere darin, daß die für die Durchführung des Verfahrens in dem Elektronenstrahlmeßgerät benötigten Meßdaten, z.B. die Koordinaten der einzelnen Meßstellen auf dem Chip der integrierten Schaltung, in besonders einfacher Weise aus den in der Arbeitsstation vorhandenen Schaltungsdaten abgeleitet und dem Elektronenstrahlmeßgerät zur Verfügung gestellt werden.

Die Ansprüche 2 bis 15 sind auf bevorzugte Ausgestaltungen und Weiterbildungen des Verfahrens nach der Erfindung gerichtet.

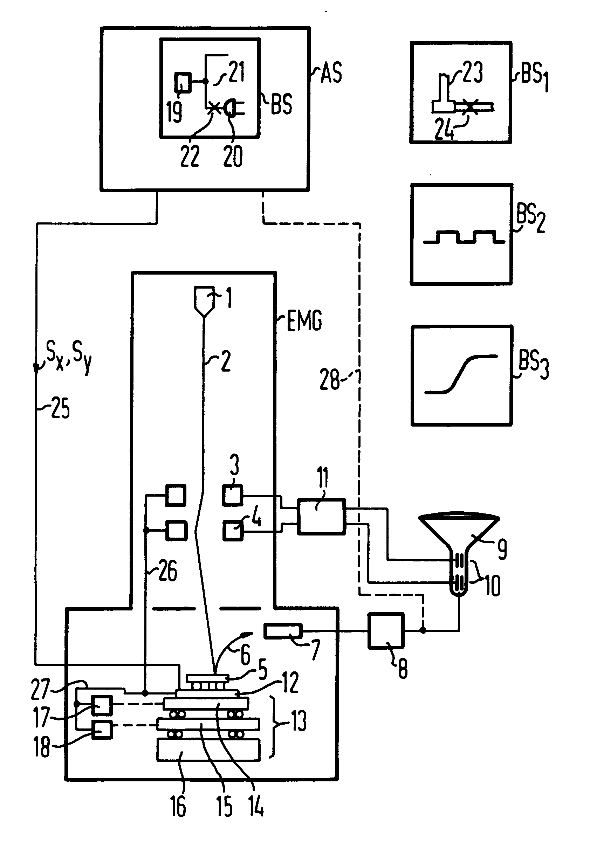

Ein bevorzugtes Ausführungsbeispiel des Verfahrens nach der Erfindung wird anschließend anhand der Zeichnung näher erläutert.

Dabei bezeichnet AS eine Arbeitsstation, die mit einem Bildschirm BS ausgestattet ist. Ein Elektronenstrahlmeßgerät EMG weist eine Anordnung 1 zur Erzeugung eines Elektronenstrahls 2 auf. Dieser durchläuft zwei Ablenksysteme 3, 4, die ihn in zwei insbesondere senkrecht zueinander stehenden Koordinatenrichtungen ablenken und trifft auf die Oberfläche einer auf einem Chip realisierten integrierten Schaltung 5, an der eine Fehleranalyse vorgenommen werden soll. An der Oberfläche von 5 treten an den von 2 getroffenen Stellen Sekundärelektronen aus, die in Richtung des Pfeils 6 zu einem Detektor 7 gelangen. Dieser leitet hieraus ein Signal ab, aus dem in einer Signalverarbeitungseinheit 8 ein Steuersignal für eine Bildröhre 9 gebildet wird, deren Strahlablenksysteme mit 10 angedeutet sind. Diese werden von einem Rastergenerator 11 angespeist, der auch die Ablenksysteme 3, 4 mit Ablenkspannungen beaufschlagt.

Die integrierte Schaltung 5, die auch als Probe bezeichnet wird, ist in einem Testbett (breadboard) 12 enthalten, das auf einem xy-Tisch 13 gelagert ist. Dieser besteht aus dem Teilen 14 bis 16, von denen das Teil 14 auf dem Teil 15 in einer ersten Ablenkrichtung x parallel verschiebbar gelagert ist, während das Teil 15 auf dem ortsfesten Unterteil 16 in einer zweiten Ablenkrichtung y parallel verschoben werden kann. Mit 17 und 18 sind Antriebseinrichtungen für die Teile 14 und 15 bezeichnet. Zur Fokussierung des Elektronenstrahls 2 benötigte Elektronenlinsen sind der Einfachheit halber in der Zeichnung nicht dargestellt.

Zur Durchführung einer Fehleranalyse an der monolithisch integrierten Schaltung 5 wird nun so vorgegangen: Zunächst stellt man den Stromlaufplan der als fehlerhaft erkannten Schaltung 5 auf dem Bildschirm BS dar. Durch einen Fehlersuchalgorithmus, der auf der Arbeitsstation AS abläuft und unter Verwendung von in der Arbeitsstation vorliegenden Test-Bitmustern (Stimuli) durchgeführt wird, wird in an sich bekannter Weise ein Störungspfad aus dem übrigen Teil des Stromlaufplanes herausgehoben. In der Zeichnung ist z.B. angedeutet, daß ein über eine Teilschaltung 19 und ein UND-Gatter 20 verlaufender Störungspfad 21 extrahiert wird.

Zweckmäßigerweise wird nun an einer Mehrzahl von Meßstellen auf diesem Störungspfad mittels des Elektronenstrahlmeßgeräts kontrolliert, ob der Fehler jeweils in Erscheinung tritt oder nicht. Diese Meßstellen werden insbesondere so über den Störungspfad verteilt, daß sie jeweils im Bereich einer Verzweigung desselben liegen.

Die Auswahl einer solchen Meßstelle erfolgt in der Weise, daß sie zunächst mittels einer Schreibmarke 22 oder durch einen Fehlersuchalgorithmus auf dem dargestellten Teil des Störungspfades (als Teil des Stromlaufplanes) markiert wird. Danach wird auf dem Bildschirm BS das Teil des Layouts der integrierten Schaltung, das der durch 22 markierten Meßstelle und ihrer unmittelbaren Umgebung entspricht, isoliert vom übrigen Layout dargestellt, was in der Zeichnung durch die Ansicht $BS_1$ von BS angedeutet ist. Der Übergang von dem dargestellten Teil 19 bis 21 des Stromlaufplans zum dargestellten Layoutteil 23 erfolgt in der Arbeitsstation durch einen vorangegangenen "electrical rule check" bzw. durch eine Rekonstruktion der Topologie aus der Topografie. Sodann wird die Meßstelle mittels einer Schreibmarke 24 auf dem dargestellten Layoutteil 23 markiert. In Abhängigkeit von der Position der einstellbaren Schreibmarke 24 erzeugt nun die Arbeitsstation Positionssignale $S_x$, $S_y$, die über ein Leitungsbündel 25 dem Testbett 12 zugeführt werden. Über eine auf diesem vorgesehene Schaltung, die bezüglich der zu untersuchenden Schaltung 5 eine periphere Schaltung darstellt und unter anderem zur Ansteuerung von 5 dient, werden aus $S_x$ und $S_y$ Steuersignale abgeleitet, die einerseits über Leitungen 26 den Ablenkeinrichtungen 3, 4 und andererseits über Leitungen 27 den Antriebseinheiten 17 und 18 zugeführt werden. Diese Steuersignale bewirken die Ausrichtung des Elektronenstrahls 2 auf die ausgewählte Meßstelle auf dem Chip der integrierten Schaltung 5. Dabei dient die Einstellung der Teile 14 und 15 als Grobeinstellung, die Ablenkung des Elektronenstrahls mittels 3 und 4 als Feineinstellung. Eine Grobeinstellung kann in Abhängigkeit von der Lage der Meßstelle auf dem Chip unter Umständen auch entfallen.

Die integrierte Schaltung 5 wird von Testsignalen gespeist, die im allgemeinen in Form von Bitmustern vorliegen und ebenfalls über das Leitungsbündel 25 aus der Arbeitsstation AS zugeführt werden. Diese können mittels einer PIN-Elektronik auch in eine wesentliche höhere Frequenzlage übertragen werden, bevor sie zur Schaltung 5 gelangen.

Der auf die Meßstelle ausgerichtete Elektronenstrahl 2 bewirkt das Austreten einer von der Spannung an der Meßstelle abhängigen Anzahl von Sekundärelektronen, so daß über die Teile 7 und 8 ein als Ist-Signal bezeichneter Spannungsverlauf gewonnen wird, der mit seiner Amplitude die an der Meßstelle auftretende Spannung jeweils wiedergibt. Die Zeitabhängigkeit des Ist-Signals kann auf der Bildröhre 9 dargestellt werden. Hierzu genügt es, daß der Rastergenerator 11 lediglich die Zeitablenkung des schreibenden Elektronenstrahls der Bildröhre 9 beeinflußt, während das über 8 gewonnene Signal eine Auslenkung von der so beschriebenen Zeitachse bewirkt. Andererseits kann das Ist-Signal auch über eine Leitung 28 der Arbeitsstation AS zugeführt und auf dem Bildschirm BS dargestellt werden.

In der Arbeitsstation AS wird ein der betrachteten Meßstelle zugeordnetes Soll-Signal mittels einer Logiksimulation erzeugt und in seiner Zeitabhängigkeit auf dem Bildschirm BS dargestellt (Ansicht $BS_2$). Ein Vergleich des Ist-Signals mit dem Soll-Signal zeigt in einfacher Weise an, ob an dieser Fehlerstelle der Fehler vorhanden ist oder nicht.

Nach einer Weiterbildung des Verfahrens kann das Ist-Signal derart zeitgedehnt dargestellt werden, daß der Übergang von dem unteren Spannungswert auf den oberen Spannungswert deutlich sichtbar wird. Zum Vergleich wird dann ein Soll-Signal verwendet, das in der Arbeitsstation durch eine Transientensimulation erzeugt wird. Ein solches Soll-Signal ist der Ansicht $BS_3$ von BS zu entnehmen.

Werden das Ist-Signal und das Soll-Signal auf dem Bildschirm BS miteinander verglichen, ist es zweckmäßig, das eine Signal z.B. durch einen Farbkontrast deutlich von dem anderen zu unterscheiden. Aus beiden Signalen kann in AS auch ein Differenzsignal gebildet werden, das die Größe der gegenseitigen Abweichung angibt.

Mit besonderem Vorteil kann auf der Arbeitsstation aus einem Testsignal, das z.B. aus einem langen Bitmuster besteht, zur Untersuchung eines bestimmten Störungspfades auch ein Teil desselben herausgegriffen werden. Das Testsignal wird also partitioniert. Sein herausgegriffener Teil wird dann periodisch durchlaufen und der integrierten Schaltung 5 über das Leitungsbündel 25 zugeführt.

Stimmt das an der durch die Schreibmarken 22 und 24 bestimmten Meßstelle gewonnene Ist-Signal mit dem Soll-Signal entsprechend $BS_2$ oder $BS_3$ nicht überein, so ist an dieser Stelle ein Meßfehler vorhanden. Wenn man in analoger Weise die übrigen Meßstellen untersucht, so kann man den Schluß ziehen, daß der Meßfehler auf dem Störungspfad zwischen einer solchen Meßstelle, die den Meßfehler noch erkennen läßt, und einer nächstfolgenden Meßstelle, an der er nicht mehr auftritt, lokalisiert werden kann.

In der Arbeitsstation können die der integrierten Schaltung 5 zugeordneten Ist-Signale, Soll-Signale und gegebenenfalls aus beiden gebildete Vergleichssignale gespeichert oder auch an Drukker, Plotter oder dgl. ausgegeben werden.

**Patentansprüche**

1. Verfahren zur Fehleranalyse an integrierten Schaltungen, bei dem
    a) die integrierte Schaltung (5) mit wenigstens einem Testsignal beaufschlagt wird,
    b) auf einem als fehlerhaft erkannten Störungspfad wenigstens eine Meßstelle ausgewählt und ein an dieser abgegriffenes Ist-Signal mit einem Soll-Signal verglichen wird,
    c) und aus den Vergleichsergebnissen an den Meßstellen der Fehlerort auf dem Störungspfad ermittelt wird,
    d) wobei ein die integrierte Schaltung (5) als Probe enthaltendes, von einer Arbeitsstation (AS) gesteuertes Elektronenstrahl-Meßgerät (EMG) zur Ermittlung des der Meßstelle zugeordneten Ist-Signals herangezogen wird,

gekennzeichnet durch folgende Merkmale:

e) die Auswahl einer Meßstelle auf dem Störungspfad erfolgt dadurch, daß auf einem Bildschirm (BS) der Arbeitsstation (AS) wenigstens der dieser Meßstelle und ihrer Umgebung entsprechende Teil des Layouts (23) der integrierten Schaltung (5) dargestellt und die Meßstelle mittels einer Schreibmarke (24) auf dem dargestellten Teil des Layouts (23) markiert wird,

f) in Abhängigkeit von der Position der einstellbaren Schreibmarke (24) werden durch die Arbeitsstation (AS) Positionssignale ($S_x$, $S_y$) erzeugt, die dem Elektronenstrahl-Meßgerät (EMG) zur Ausrichtung des Elektronenstrahls (2) auf die ausgewählte Meßstelle zugeführt werden.

2. Verfahren nach Anspruch 1, **dadurch gekennzeichnet,** daß zur Auswahl der Meßstelle zunächst der Stromlaufplan der integrierten Schaltung auf dem Bildschirm (BS) der Arbeitsstation dargestellt wird, daß die Meßstelle im Stromlaufplan markiert wird, daß der der markierten Meßstelle und ihrer Umgebung entsprechende Teil des Layouts (23) der integrierten Schaltung dargestellt wird, und daß die Markierung der Meßstelle mittels der Schreibmarke (24) in diesem Teil des Layouts (23) erfolgt.

3. Verfahren nach Anspruch 2, **dadurch gekennzeichnet,** daß nach dem Erkennen eines Störungspfades die Darstellung des Stromlaufplans im wesentlichen auf diesen beschränkt wird.

4. Verfahren nach einem der Ansprüche 1 bis 3, **dadurch gekennzeichnet,** daß die Meßstellen so ausgewählt werden, daß sie an den Verzweigungen des Störungspfades liegen.

5. Verfahren nach einem der Ansprüche 1 bis 4, **dadurch gekennzeichnet,** daß die Positionssignale den Ablenkeinrichtungen (3, 4) und/oder den Steuerungen der Antriebseinrichtungen (17, 18) des verschiebbar gelagerten, die Probe haltenden Tisches (13) eines Elektronenstrahlmeßgeräts (EMG) zugeführt werden.

6. Verfahren nach Anspruch 5, **dadurch gekennzeichnet,** daß als Elektronenstrahlmeßgerät (EMG) ein Raster-Elektronenmikroskop verwendet wird, das zur Abnahme von Spannungswerten an einzelnen Meßpunkten einer als Probe eingesetzten integrierten Schaltung (5) eingerichtet ist.

7. Verfahren nach einem der Ansprüche 1 bis 6, **dadurch gekennzeichnet,** daß die Positionssignale über ein die integrierte Schaltung enthaltendes Testbett (breadboard) (12) abgeleitet werden.

8. Verfahren nach einem der Ansprüche 1 bis 7, **dadurch gekennzeichnet,** daß das mit dem abgegriffenen Ist-Signal verglichene Soll-Signal in der Arbeitsstation (AS) mittels einer Logiksimulation erhalten wird.

9. Verfahren nach einem der Ansprüche 1 bis 7, **dadurch gekennzeichnet,** daß das mit dem abgegriffenen Ist-Signal verglichene Soll-Signal in der Arbeitsstation (AS) mittels einer Transientensimulation erhalten wird.

10. Verfahren nach einem der Ansprüche 1 bis 9, **dadurch gekennzeichnet,** daß das Testsignal aus einem Test-Bitmuster besteht.

11. Verfahren nach Anspruch 10, **dadurch gekennzeichnet,** daß das Testsignal aus einem in der Arbeitsstation gebildeten Teil des Test-Bitmusters besteht, das periodisch durchlaufen wird.

12. Verfahren nach einem der Ansprüche 1 bis 11, **dadurch gekennzeichnet,** daß das der integrierten Schaltung (5) aus der Arbeitsstation (AS) zugeführte Testsignal über eine Elektronikschaltung in eine höhere Frequenzlage umgesetzt wird.

13. Verfahren nach einem der Ansprüche 1 bis 12, **dadurch gekennzeichnet,** daß das Soll-Signal aus einem in der Arbeitsstation gebildeten ersten Spannungsverlauf besteht, der auf einem Sichtgerät, insbesondere auf dem Bildschirm der Arbeitsstation, dargestellt wird, und daß das Ist-Signal aus einem zweiten Spannungsverlauf besteht, der insbesondere auf demselben Sichtgerät in Kontrast zu dem ersten Spannungsverlauf dargestellt wird.

14. Verfahren nach einem der vorhergehenden Ansprüche, **dadurch gekennzeichnet,** daß der integrierten Schaltung zugeordnete Ist-Signale, Soll-Signale und gegebenenfalls aus beiden gebildete Vergleichssignale in der Arbeitsstation gespeichert werden.

15. Verfahren nach Anspruch 14, **dadurch gekennzeichnet,** daß in der Arbeitsstation gespeicherte Ist-Signale, Soll-Signale und/oder Vergleichssignale auf einen Drucker, Plotter oder dgl. ausgegeben werden.

**Claims**

1. Method of fault analysis in integrated circuits, in which
   a) at least one test signal is applied to the integrated circuit (5),
   b) on a disruption path recognised as faulty at least one measurement point is chosen an an actual value signal tapped at this point is compared with a theoretical value signal,
   c) the location of the fault on the disruption path is determined from the comparison results at the measurement points,
   d) and an electron beam measuring device (EMG) which contains the integrated circuit (5) as a testpiece and is controlled by a work station (AS) is used to determine the actual value signal co-ordinated with the measurement point,
   characterised by the following features:
   e) the choice of a measurement point on the disruption path is made in that at least the part of the layout (23) of the integrated circuit (5) corresponding to this measurement point and its surroundings is displayed on a display screen (BS) of the work station (AS) and the measurement point is marked by means of a record mark (24) on the displayed part of the layout (23),
   f) depending upon the position of the adjustable record mark (24) position signals ($S_x$, $S_y$) are generated by the work station (AS) which are delivered to the electron beam measuring device (EMG) for alignment of the electron beam (2) on the chosen measurement point.

2. Method as claimed in claim 1, characterised in that for selection of the measurement point first of all the circuit diagram of the integrated circuit is displayed on the display screen (BS) of the work station, the measurement point is marked in the circuit diagram, the part of the layout (23) of the integrated circuit corresponding to the marked measurement point and its surroundings is displayed, and the marking of the measurement point is carried out in this part of the layout (23) by means of the record mark (24).

3. Method as claimed in claim 2, characterised in that after a disruption path has been recognised the display of the circuit diagram is essentially restricted to this disruption path.

4. Method as claimed in one of claims 1 to 3, characterised in that the measurement points are chosen so that they lie at the branches of the disruption path.

5. Method as claimed in one of claims 1 to 4, characterised in that the position signals are delivered to the deflection arrangements (3, 4) and/or the controls for the drive arrangements (17, 18) of the movably mounted table (13) holding the testpiece in an electron beam measuring device (EMG).

6. Method as claimed in claim 5, characterised in that a scanning electron microscope which is set up to take voltage values at individual measurement points on an integrated circuit (5) used as a testpiece is used as the electron beam measuring device (EMG).

7. Method as claimed in one of claims 1 to 6, characterised in that the position signals are derived via a test bed (breadboard) 12 containing the integrated circuit.

8. Method as claimed in one of claims 1 to 7, characterised in that the theoretical value signal which is compared with the tapped actual value signal is obtained in the work station (AS) by means of a logic simulation.

9. Method as claimed in one of claims 1 to 7, characterised in that the theoretical value signal which is compared with the tapped actual value signal is obtained in the work station (AS) by means of a transient simulation.

10. Method as claimed in one of claims 1 to 9, characterised in that the test signal consists of a test bit pattern.

11. Method as claimed in claim 10, characterised in that the test signal consists of a part of the test bit pattern which is formed in the work station and is periodically run through.

12. Method as claimed in one of claims 1 to 11, characterised in that the test signal delivered to the integrated circuit (5) from the work station (AS) is converted via an electronic circuit into a higher frequency state.

13. Method as claimed in one of claims 1 to 12, characterised in that the theoretical value signal consists of a first voltage variation which is formed in the work station and which is displayed on a visual display unit, particularly the display screen of the work station, and that the actual value signal consists of a second voltage variation which is displayed in particular on the same visual display unit in contrast to the first voltage variation.

14. Method as claimed in one of the preceding claims, characterised in that actual value signals co-ordinated with the integrated circuit, theoretical value signals and optionally comparison signals formed from both of them are stored in the work station.

15. Method as claimed in claim 14, characterised in that actual value signals, theoretical value signals and/or comparison signals stored in the work station are passed to a printer, plotter or the like.

**Revendications**

1. Procédé d'analyse de défauts de circuits intégrés, suivant lequel

a) au moins un signal de test est envoyé au circuit intégré (5),

b) au moins un lieu de mesure est sélectionné sur une voie parasite reconnue comme défectueuse et un signal réel tiré de ce lieu est comparé avec un signal de consigne,

c) et l'emplacement du défaut sur la voie parasite est déterminé par les résultats de la comparaison aux lieux de mesure,

d) un appareil de mesure à faisceau électronique (ENG) qui renferme le circuit intégré (5) sous forme d'échantillon et qui est commandé par un poste de travail (AS) étant utilisé pour la détermination du signal réel affecté au lieu de mesure,

caractérisé par les particularités suivantes :

e) la sélection du lieu de mesure sur la voie parasite s'effectue par représentation, sur un écran (BS) du poste de travail (AS), d'au moins la partie du schéma de montage (23) du circuit intégré (5) qui correspond à ce lieu de mesure et à son environnement et par indication du lieu de mesure au moyen d'un repère (24) sur la partie représentée du schéma de montage (23),

f) le poste de travail (AS) génère, en fonction de la position du repère réglable (24), des signaux de position ($S_x$, $S_y$) qui sont envoyés à l'appareil de mesure par faisceau électronique (MEG) pour l'orientation du faisceau électronique (2) sur le lieu de mesure sélectionné.

2. Procédé selon la revendication 1, caractérisé en ce que tout d'abord le schéma des connexions du circuit intégré est représenté sur l'écran (BS) du poste de travail pour la sélection du lieu de mesure, en ce que le lieu de mesure est repéré sur le schéma des connexions, en ce que la partie du schéma de montage (23) du circuit intégré qui correspond au lieu de mesure repéré et à son environnement est représentée et en ce que l'indication du lieu de mesure par le repère (24) est effectuée dans cette partie du schéma de montage (23).

3. Procédé selon la revendication 2, caractérisé en ce qu'après détection d'une voie parasite, la représentation du schéma des connections est limitée essentiellement à cette voie.

4. Procédé selon l'une des revendications 1 à 3, caractérisé en ce que les lieux de mesure sont sélectionnés de manière qu'ils soient situés en des embranchements de la voie parasite.

5. Procédé selon l'une des revendications 1 à 4, caractérisé en ce que les signaux de position sont dirigés sur les dispositifs de déviation (3, 4) et/ou les commandes des dispositifs (17, 18) d'entraînement de la table (13) d'un appareil de mesure à faisceau électronique (EMG) qui est montée translatable et qui supporte l'échantillon.

6. Procédé selon la revendication 5, caractérisé en ce que l'appareil de mesure à faisceau électronique (EMG) qui est utilisé est un microscope électronique à balayage qui est conçu pour prélever des tensions en des points individuels de mesure d'un circuit intégré (5) utilisé en échantillon.

7. Procédé selon l'une des revendications 1 à 6, caractérisé en ce que les signaux de position sont élaborés au moyen d'un montage expérimental (breadboard) (12) contenant le circuit intégré.

8. Procédé selon l'une des revendications 1 à 7, caractérisé en ce que le signal de consigne comparé au signal réel prélevé est obtenu au poste de travail (AS) par une simulation logique.

9. Procédé selon l'une des revendications 1 à 7, caractérisé en ce que le signal de consigne comparé au signal réel prélevé est obtenu au poste de travail (AS) par une simulation transitoire.

10. Procédé selon l'une des revendications 1 à 9, caractérisé en ce que le signal de test se compose d'une séquence de bits de test.

**11.** Procédé selon la revendication 10, caractérisé en ce que le signal de test se compose d'une partie de la séquence de bits de test qui est formée au poste de travail et que l'on fait passer périodiquement.

**12.** Procédé selon l'une des revendications 1 à 11, caractérisé en ce que le signal de test dirigé du poste de travail (AS) sur le circuit intégré (5) est converti par un circuit électronique à une position supérieure en fréquence.

**13.** Procédé selon l'une des revendications 1 à 12, caractérisé en ce que le signal de consigne se compose d'une première variation de tension formée au poste de travail et représentée sur un appareil de visualisation, en particulier sur l'écran du poste de travail et en ce que le signal réel se compose d'une seconde variation de tension qui est représentée en particulier sur le même appareil de visualisation en contraste avec la première variation de tension.

**14.** Procédé selon l'une des revendications précédentes, caractérisé en ce que les signaux réels, signaux de consigne et éventuellement signaux de comparaison formés des deux premiers, qui sont affectés au circuit intégré, sont mémorisés au poste de travail.

**15.** Procédé selon la revendication 14, caractérisé en ce que les signaux réels, signaux de consigne et/ou signaux de comparaison mémorisés au poste de travail sont reproduits par une imprimante, un traçeur de courbes ou analogue.